Europäisches Patentamt

(19) European Patent Office

Office européen des brevets

(11) Publication number: 0 105 565
A1

(12) **EUROPEAN PATENT APPLICATION**

(21) Application number: 83201397.3

(22) Date of filing: 28.09.83

(51) Int. Cl.³: **G 01 N 24/06**
**H 01 F 7/22**

(30) Priority: 28.09.82 NL 8203756

(43) Date of publication of application:
18.04.84 Bulletin 84/16

(84) Designated Contracting States:
CH DE FR GB IT LI NL

(71) Applicant: Holec N.V.
Stationsplein 93 Hoog Catharijne
NL-3511 ED Utrecht(NL)

(72) Inventor: Van de Klundert, Louis Johannes Maria
No. 76, Horstlindelaan
NL-7522 JJ Enschede(NL)

(74) Representative: 't Jong, Bastiaan Jacobus et al,
OCTROOIBUREAU ARNOLD & SIEDSMA Sweelinckplein
1
NL-2517 GK 's-Gravenhage(NL)

(54) Magnet coil device.

(57) A magnet coil device (1) for producing a magnetic field
of a defined shape, for example, a homogeneous magnetic
field for nuclear magnetic resonance techniques comprising
at least four and preferably seven main coils (3) and a frame
(2) comprising a cylinder of non-ferromagnetic material, in
the periphery of which channels (7) accommodating the coils
(3) are recessed.

FIG.1

Eur.pat.appln. 83201397.3
encl. with letter of October 7,
1983.

**0105565**

T/Holec-1-EU

## Magnet coil device

The invention relates to a magnet coil device for producing a magnetic field having a defined shape, for example, a homogeneous magnetic field for nuclear magnetic resonance techniques comprising a frame and a plurality of main coils fastened to said frame.

Such a device is known from European Patent Application 72200649.6. This known device comprises four coils or else two pairs having different mean diameters. The pair of coils having the larger diameter is located between the pair having the smaller diameter. This magnet coil device is employed for assessing the internal structure of the human body with the aid of nuclear magnetic resonance. This technique is known _per se_. For this application the magnetic field produced has to satisfy severe requirements of uniformity and magnitude. In the measuring range the relative deviations must not exceed, for example, $10^{-5}$-th whilst the magnitude of the field in certain cases amounts to 2 T (tesla). The forces occurring at this field magnitude in such a device are of the order of magnitude of 40 MN with coil diameters of 1 metre and a field of 2 T. These enormous forces have to be taken up by the frame. Moreover, the coils have to remain accurately coaxial with one another and the relative distance must not vary by more than a calculated measure. If this is not fulfilled the required uniformity cannot be obtained. It is very difficult to satisfy these requirements by the known magnet coil devices. Also another known magnet coil device comprising a solenoid having at both ends compensation head coils can satisfy these requirements only with great difficulty.

The object of the present invention is to provide a magnet coil device of the kind set forth in the preamble by which the magnetic field to be produced will have the desired shape with a high degree of accuracy.

In a magnet coil device embodying the invention this is achieved in that this device comprises at least four and preferably at least seven main coils and the frame comprises a cylinder of non-ferromagnetic material, in the periphery of which are recessed channels receiving the coils. Owing to the relatively large number of main coils it is possible to adapt them to a cylindrical shape of the frame which is favourable to obtain great rigidity. Each coil has a number of parameters which determine the magnetic field to be produced. These parameters are the axial location, the diameter, the thickness, the width and the current density of the coil. When in accordance with the invention at least four and preferably at least seven main coils are used, a number of these parameters can be freely chosen for each coil, whilst still sufficient parameters are left to obtain the desired shape of the magnetic field. By freely choosing in the manner described the mean diameter of each coil, in particular so that the nominal diameters are substantially equal, that is to say, the mean diameters are at the most different by half the thickness of the thickest coil, the frame can obtain this structurally very advantageous shape of a cylinder. The path of forces between the magnet coils is in this shape of the frame as short as possible and, moreover, the forces solely extend in an axial direction in the cylinder sheath so that for the desired accuracy a very advantageous, rigid structure is obtained.

In a further advantageous embodiment of the invention the thickness and the width of each main coil are equal to an integral number of times the nominal, radial, respectively axial distance between two turns of the conductor being in contact in a radial and an axial direction respectively. With this choice of the thickness and the width of each main coil it is ensured that the conductor is very accurately positioned in the coil. Therefore, the current distribution along the sectional area of the coil will be uniform so that the influence of each coil on the magnetic field corresponds as satisfactorily as possible with the calculated influence.

The overall thickness of the magnet coils can be limited to less than one tenth of the mean radius of the coils so that the space occupied by the device is comparatively small and the minimum working height may have an advantageous low value.

The length-diameter ratio of the device can also be limited. In a system of eight coils this ratio may have the advantageous value of about 3:2.

The cylindrical frame embodying the invention is preferably manufactured by centrifugal casting. The cylinder will thus have a homogeneous composition, which is again. advantageous for obtaining the desired accuracy of the magnetic field.

The above-mentioned field strength of 2 T is preferably generated by supraconductive coils. The device embodying the invention has the additional advantage that it is particularly suitable for such a use. The cryogenic vacuum vessel in which the supraconductive coils have to be arranged has an advantageous, simple form from the production-technical point of view. In a preferred embodiment the cylinder forms part of the wall of the cryogenic vessel.

In a further embodiment the cylinder forms part of the heat exchanger ensuring the cooling of the coils.

It is common practice to compensate the discrepancies of the magnetic field finally generated by supraconductive coils due to manufacturing tolerances by means of auxiliary coils. According to the invention in the magnet coil device each main coil has joined to it two pairs of auxiliary coils in close proximity. Since a relatively large number of small main coils is used, the errors are localized in small regions. By using two pairs of auxiliary coils with each main coil the errors can be locally compensated in this small region. The current strengths required thereto are relatively low.

The invention will be described more fully with reference to the accompanying drawings of embodiments.

Fig. 1 is a very schematic sectional view of the magnet coil device embodying the invention.

Fig. 2 shows a different embodiment of the magnet coil device in accordance with the invention.

Fig. 3 is an elevational view in the direction of the arrow III in Fig. 2.

Figs. 4 and 5 are schematic graphs to elucidate the operation of the auxiliary coils.

The magnet coil device 1 comprises a frame 2 and a plurality of main coils 3 fastened to the frame 2. The main coils 3 are connected with an electric current source so that in the interior of the frame 2 a magnetic field of a defined shape is generated. The magnet coil device 1 is particularly intended for generating a homogeneous magnetic field in order to assess the internal structure of a patiens's body 5 with the aid of known nuclear magnetic resonance techniques. For this purpose the patient 5 lies on a table 4 in the interior of the frame 2. Apart from the homogeneous, constant magnetic field to be produced by the device, an alternating magnetic field is generated in this case with the aid of an additional coil set (not shown).

According to the invention the device 1 comprises at least four and in this case seven main coils 3. Since each main coil 3 has a number of parameters acting upon the shape of the magnetic field to be produced, the use of a relatively large number of main coils provides a relatively large number of potential designs. The value of some parameters is chosen so that an advantageous construction can be obtained. In the magnet coil device embodying the invention shown herein the diameters of all main coils are equal to one another and the thicknesses of the main coils are chosen to be equal. Moreover, for example, the current strength in each main coil may be chosen to be the same so that a single feed will suffise.

The device 1 comprises as a frame 2 a cylinder in the periphery of which channels 7 are recessed for accommodating the main coils 3. The main coils can be directly wound in the channels 7 of the cylinder 2 so that after impregnation of the wound coils a structurally very rigid unit is obtained.

The only minor deviations from the desired shape of the magnetic field can be compensated in known manner by means of auxiliary coils 6 arranged around the main coils.

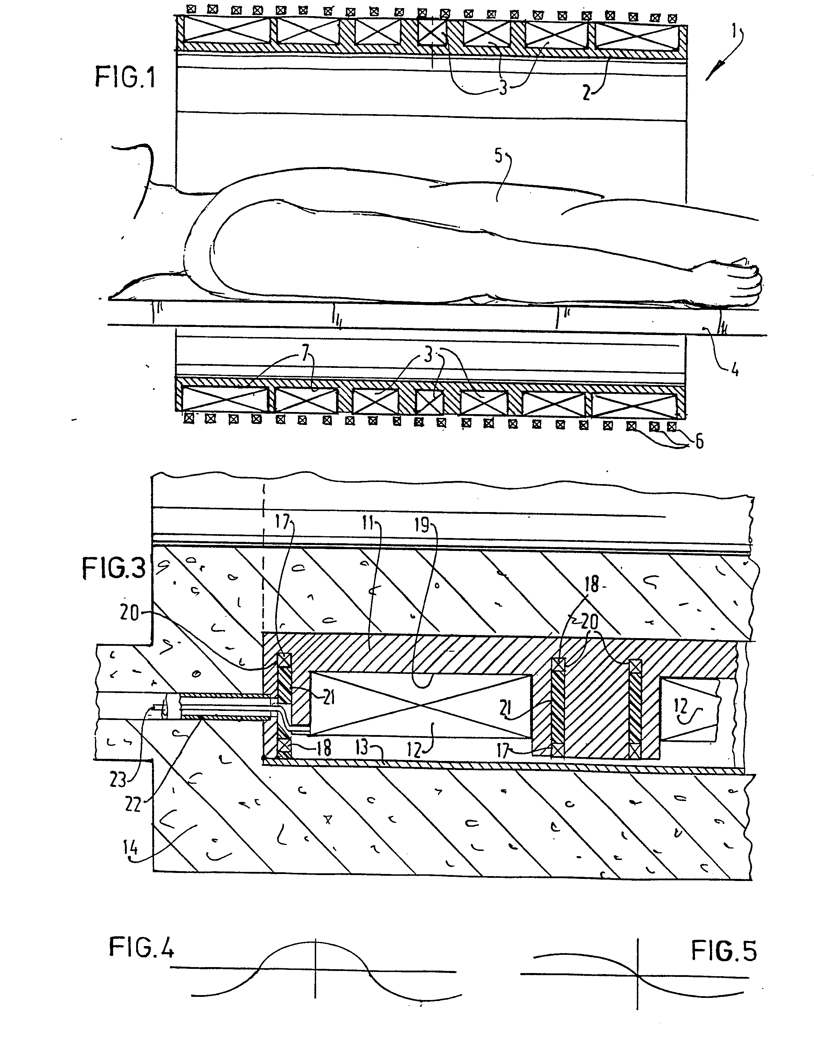

Owing to the great freedom in design provided by the invention a magnet coil device embodying the invention can be very advantageously manufactured in which supraconduction is used. Such a device 10 is schematically shown in Figs. 2 and 3. In this device 10 the frame also has the form of a cylinder 11 with channels 19 in its periphery, in which the main coils 12 are wound.

The cylinder 11 is centrifugally cast so that the structure of the material is homogeneous. Welding seams might produce irregularities in the magnetic field to be produced.

The cylinder 11 together with a closing plate 13 surrounding the outer circumference and a thick thermally insulating layer 14 formed by radiation screens and supra-insulation in vacuo constitutes a cryogenic vessel. Through a feed duct 22 shown schematically this vessel is charged with a suitable fluid such as liquid helium, which is conducted away through an identical outlet duct (not shown). In a further embodiment the cylinder 11 may be a wall of a heat exchanger traversed by gaseous or supracritical helium. An important advantage of the invention, when supraconduction is applied, is that the main coils 12 are relatively small so that for each coil a single length of supraconductive wire can be used. In the coils themselves conductor welds are lacking, which is advantageous because welds in supraconductive wire do not possess supraconductive properties.

A further advantage is that owing to the great freedom in design for all coils the same kind of conductor can be employed. Therefore, from a single, suitable supraconductive conductor of constant diameter a great plurality of conductors can be made so that the costs are limited.

In connection with the use of supraconduction it is a further advantage that in a magnet coil device embodying the invention the ratio between the maximum field strength in the coils and the magnetic field strength desired in the central measuring region is low. This is advantageous because above a given field strength which decreases with an increasing current, the supraconductive material loses its supraconductive properties. Therefore, when said ratio is low a high field strength as desired can be produced or it will be sufficient to use less supraconductive material. In this case, moreover, the forces involved remain low.

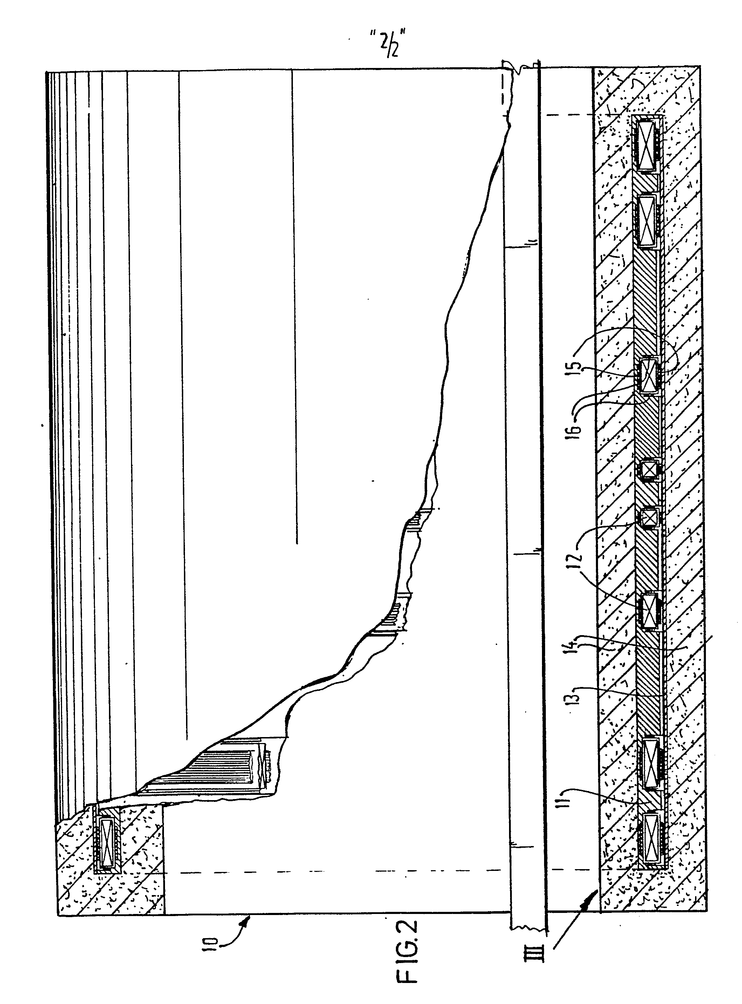

According to one aspect of the invention two pairs of auxiliary coils 15, 16, preferably wound in opposite senses, are arranged near each main coil 12. These auxiliary coils serve to compensate the field errors produced by deviations of the manufactured coils with respect to the calculated values. Due to these deviations the magnetic field generated by the main coils 12 will not accurately have the desired shape. Since the coils 12 have small thicknesses and widths in accordance with the invention, the errors are localized in a small region. It is thus effectively possible to compensate the errors in the area of each main coil with the aid of the auxiliary coils 15, 16. The field errors caused by deviations in the main coils are schematically illustrated in Figs. 4 and 5. The vertical line in Fig. 5 represents the central plane of the coil concerned, whilst the straight, horizontal line represents the ideal field form of the device. The curved line schematically indicates the virtual form. The deformation shown in Fig. 4 is due to deviations from the nominal diameter, the thickness and the width of the coil. These errors are compensated by means of the pair of coils 15 lying in the same axial plane as the main coil 12 concerned and being wound in opposite senses. The currents through these coils produce in opposite senses magnetic moments substantially equal in absolute value.

A field deviation as shown in Fig. 5 occurs due to an error in the axial location of the main coil concerned. This error is compensated by the pair of coils 16 arranged on both sides of the main coil 12 concerned. The coupling of the pairs of coils 15, 16 with the main coil is negligible. Starting with a reasonable initial accuracy the compensation by the pairs of coils 15, 16 renders redundant an integral correction system as schematically indicated by 6 in Fig. 1.

Apart from the manner shown in Fig. 2 the auxiliary coils may also be diagonally with respect to the sectional area of the main coil. This variant is shown in Fig. 3. The pairs of auxiliary coils 17 and 28 are arranged in separate channels 20 provided on both sides of the channels 19 for the main coils 12. On the bottom of the channel 20 concerned one coil 17, 18 is disposed after which the channel 20 is further filled out with a filling piece 21. At a diameter located near the outer diameter of the main coil 12 the other two auxiliary coils 17, 18 are subsequently formed. The coils of the pairs 17, 18 are again wound in opposite senses. It will be obvious that as compared with the arrangement of Fig. 2 the currents in the auxiliary coils have to be resolved in order to obtain a corresponding correction effect.

Fig. 3 furthermore shows that the connection 23 of the coils is passed through a feed channel 22 for the cryogenic fluid. As a matter of course other constructions may be employed.

The cylindrical frame of the device embodying the invention need not be an integral unit. It may, as an alternative, be formed by two or more interconnected parts, which are separately wound.

CLAIMS
-----------

1. A magnet coil device for producing a magnetic field of a defined shape, for example, a homogeneous magnetic field for nuclear magnetic resonance techniques comprising a frame and a plurality of main coils fastened to said frame characterized in that the device comprises at least four main coils and in that the frame comprises a cylinder of non-ferromagnetic material, in the periphery of which channels accommodating the coils are recessed.

2. A device as claimed in Claim 1 characterized in that it comprises at least seven main coils.

3. A device as claimed in Claim 1 or 2 characterized in that the channels have substantially the same nominal diameter.

4. A device as claimed in Claim 1, 2 or 3 characterized in that the thickness and the width of each main coil are equal to an integral number of times the nominal radial and, respectively axial distance in the winding mode used between two contacting turns of the conductor in a radial or axial direction respectively.

5. A device as claimed in anyone of the preceding claims characterized in that the cylinder is centrifugally cast.

6. A device as claimed in anyone of the preceding

claims c h a r a c t e r i z e d in that the cylinder is made from stainless steel.

7. A device as claimed in anyone of the preceding claims c h a r a c t e r i z e d in that to each main coil are added two pairs of auxiliary coils arranged in close proximity of said main coil.

8. A device as claimed in anyone of the preceding claims c h a r a c t e r i z e d in that the conductors are supraconductors and the device comprises a cryogenic vessel enclosing at least the coils.

9. A device as claimed in Claim 8 c h a r a c- t e r i z e d in that the cylinder forms part of the wall of the cryogenic vessel.

10. A device as claimed in Claim 8 c h a r a c- t e r i z e d in that the cylinder is part of a heat-exchanger ensuring the cooling of the coils.

"½"

FIG.1

FIG.3

FIG.4

FIG.5

FIG.2

### European Patent Office

## DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| A | GB-A-2 070 254 (THE OXFORD INSTRUMENTS GROUP LIMITED) * Page 7, line 61 - page 8, line 10; page 8, line 65 - page 9, line 15; figure 3 * | 1-3 | G 01 N 24/06 H 01 F 7/22 |
| | --- | | |
| A | JOURNAL OF PHYSICS E SCIENTIFIC-INSTRUMENTS, vol. 5, no. 7, July 1972, pages 663-666, London, GB P.O. GARDEN: "Design and construction of the inner solenoid of the ANU 30 T electromagnet" * Secties 1,2,5,8; figures 1-3 * | 1,8-10 | |
| | --- | | |
| A,D | EP-A-0 011 335 (PHILIPS PATENTVERWALTUNG GmbH) * Page 1, lines 1-16; page 10, lines 1-25; figure 3a * | 1,7 | |
| | --- | | TECHNICAL FIELDS SEARCHED (Int. Cl. ³) |
| A | EP-A-0 033 703 (THOMSON-CSF) * Page 8, lines 1-15; figure 1 * | 1,7 | A 61 B 5/05 G 01 N 24/04 G 01 N 24/06 |
| | --- | | G 01 N 24/08 |
| A | US-A-3 419 904 (H.E. WEAVER et al.) * Column 1, lines 35-70; column 6, lines 34-47; figure 3 * | 1,8 | H 01 F 7/20 H 01 F 7/22 |
| | ---     -/- | | |

The present search report has been drawn up for all claims

| Place of search THE HAGUE | Date of completion of the search 10-01-1984 | Examiner HORAK G.I. |
|---|---|---|

## European Patent Office

## EUROPEAN SEARCH REPORT

| | DOCUMENTS CONSIDERED TO BE RELEVANT | | Page 2 |
|---|---|---|---|

| Category | Citation of document with indication, where appropriate, of relevant passages | Relevant to claim | CLASSIFICATION OF THE APPLICATION (Int. Cl. ³) |
|---|---|---|---|
| A | REVIEW OF SCIENTIFIC INSTRUMENTS, vol. 52, no. 10, October 1981, pages 1501-1508, New York, US<br>H. SAINT-JALMES et al.: "Optimization of homogeneous electromagnetic coil systems: application to whole-body NMR imaging magnets" * Introduction and sectie IV; figure 3 * | 1,7 | |

TECHNICAL FIELDS SEARCHED (Int. Cl. ³)

The present search report has been drawn up for all claims

| Place of search | Date of completion of the search | Examiner |
|---|---|---|
| THE HAGUE | 10-01-1984 | HORAK G.I. |